(19) Europäisches Patentamt
European Patent Office
Office européen des brevets

(11) **EP 4 312 038 A1**

(12) **EUROPEAN PATENT APPLICATION**

(43) Date of publication:
**31.01.2024 Bulletin 2024/05**

(21) Application number: **22306133.4**

(22) Date of filing: **28.07.2022**

(51) International Patent Classification (IPC):
***G01R 31/367*** *(2019.01)*     ***G01R 31/392*** *(2019.01)*
***G06F 17/18*** *(2006.01)*

(52) Cooperative Patent Classification (CPC):
**G01R 31/367; G01R 31/392;** G06F 17/18

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
- **TotalEnergies OneTech
  92400 Courbevoie (FR)**
- **Université de Lorraine
  54000 Nancy (FR)**
- **Centre national de la recherche scientifique
  75016 Paris (FR)**

(72) Inventors:
- **LARVARON, Benjamin
  94270 LE KREMLIN-BICETRE (FR)**
- **BERTONCELLO, Antoine
  92430 MARNES-LA-COQUETTE (FR)**
- **CLAUSEL, Marianne
  54000 NANCY (FR)**
- **BENJAMIN, Sébastien
  33850 LEOGNAN (FR)**
- **OPPENHEIM, Georges
  75005 PARIS (FR)**

(74) Representative: **Plasseraud IP
66, rue de la Chaussée d'Antin
75440 Paris Cedex 09 (FR)**

(54) **A METHOD FOR CHARACTERIZING THE EVOLUTION OF STATE OF HEALTH OF A DEVICE WITH DURATION OF OPERATION**

(57)     It is disclosed a computer-implemented method for characterizing the evolution with duration of operation of the state of health of a population of devices, the method comprising training a model on a database comprising, for each device among the population of devices, a value of duration of operation of the device and a corresponding state of health of the device, said model being a random process comprising at least the sum of:
- a term representing average evolution of the state of health of the population with duration of operation, and
- a term representing an inter-device variability of the degradation of the state of health at equal duration of operation, the variance of said term evolving with the duration of operation.

FIG. 2

EP 4 312 038 A1

**Description**

TECHNICAL FIELD

The present disclosure relates to a method for characterizing the evolution state of health of a population of devices according to duration of operation. The present disclosure can be applied in particular to the prediction of the state of health of batteries and fuel cells.

STATE OF THE ART

Important efforts are made to find alternatives to fossil energies. These alternatives increase considerably the use of electrical energy, with an increased need of storage of electricity and of alternative modes of production of electricity.

Regarding storage of electricity, batteries, in particular lithium-ion batteries, are a preferred solution for many applications, due to their falling costs and high physical performance: high energy efficiency, long cycle life, high energy density and high power density.

Regarding alternative modes of production of electricity, hydrogen fuel cells are considered as a very promising in particular in the field of transports.

A limiting aspect of electrical batteries and fuel cells is that they age with time. Depending on their composition and conditions of use, their performance degrade until they are considered unfit for their designed use. This time corresponds to their lifetime.

For manufacturers and operators, knowledge of the aging process is a major issue to determine the optimal duration of operation for a given model and plan maintenance or replacement operations.

Regarding the case of batteries, to quantify the aging behavior of a new kind of battery, manufacturers perform a series of aging tests in controlled experimental conditions on a batch of batteries. The degradation is quantified thanks to state of health indicators such as capacity or internal resistance. However, these tests are expensive and time consuming, so generally, only few batteries are tested. The data is then used to model the typical evolution with duration of operation of the state of health.

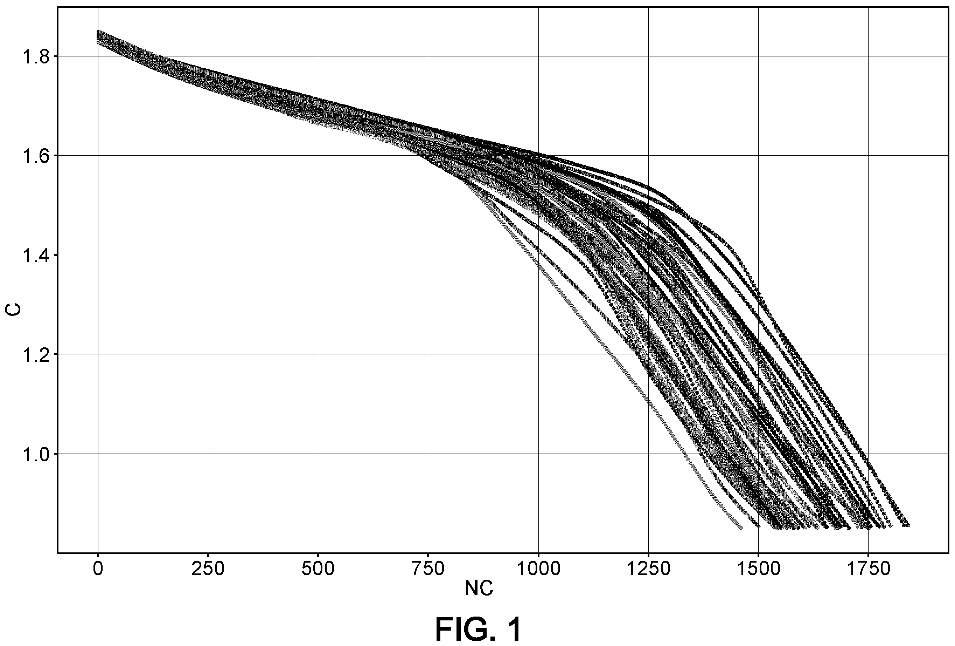

However, such modelling requires to account for the variability of the phenomenon of degradation of the health of state with time, because it enables determining the extreme ageing cases that are quicker or slower than average. With reference to figure 1, representing capacity measurements for 47 batteries, considering a batch of batteries with similar design and cycled at identical conditions, an important range of state of health may be observed after a fixed time. Figure 1 represents the capacity C of a battery as a function of a number of cycles NC. As can be seen on the figure, the uncertainty increases with time, since at cycle 100 it is approximatively of 1% of the nominal capacity, whereas at cycle 1300 it is close to 20%.

It is thus needed to model accurately this variability of the evolution of the state of health. The same considerations apply for fuel cells.

It is known for instance from:

- R. Richardson et al, "Gaussian Process Regression for forecasting battery state of health", in Journal of Power Sources, 357:209-219, 2017, and
- D. Liu et al, "Prognostics for state of health estimation of lithium-ion batteries based on combination gaussian processes functional regression", in Microelectronics Reliability, 53(6):832-839, 2013,

methods for predicting the future capacity of a battery, by application of Gaussian process regressions.

However, the models that are relied upon in these articles rely on stationarity assumptions and do not accurately account for the evolution with time of the inter-battery variability in capacity.

PRESENTATION OF THE INVENTION

In view of the above, the present disclosure aims at proposing a method for characterizing the evolution of the state of health of a device with duration of operation, that accurately renders the evolution with duration of operation of the inter-device variability in state of health.

Another aim of the invention is to provide an interpretable model in which the different sources of uncertainty are decomposed.

Accordingly, a computer-implemented method for characterizing the evolution of the state of health of a population of devices with duration of operation, the method comprising training a model on a database comprising, for each device among the population of devices, a value of duration of operation of the device and a corresponding state of health of the device, said model being a random process comprising at least the sum of:

- a term representing average evolution of the state of health of the population with duration of operation, and
- a term representing an inter-device variability of the degradation of the state of health at equal duration of operation, the variance of said term evolving with the duration of operation.

In embodiments, the method further comprises inferring, from said training, a mean value and associated uncertainty of the state of health of devices of the population, for at least one duration of operation.

In embodiments, the term representing average evolution of the quantity with duration of exploitation is a Gaussian process.

In embodiments, the term of the regression function representing inter-device variability is a non-linear combination of random processes.

In embodiments, the term of the regression function representing inter-device variability is a non-linear combination of Gaussian Processes.

In embodiments, the term of the regression function representing inter-device variability is a product of:

- a first Gaussian Process, corresponding to a deviation of the predicted quantity from the average, said first Gaussian Process having constant variance with duration of operation, and
- a positive transform of a second Gaussian Process, corresponding to the evolution of the variation of the deviation with duration of operation.

In embodiments, the model is approximated by variational inference.

In embodiments, said training comprises adding to the database data representative of the tendency, with duration of operation, of at least one term of the model.

In embodiments, said training comprises adding to the database data representative of the monotony or concavity, with duration of operation, of at least one term of the model.

In embodiments, the database comprises, for the population of devices, values of state of health corresponding to values of duration of operation that are below a maximum duration of operation, and the method further comprises inferring, from said training, a mean value and associated uncertainty of the state of health of devices of the population, for at least one duration of operation exceeding said maximum duration of operation.

In embodiments, the method further comprises determining, from said training, an expected lifetime of a device of a same model that the devices of the population.

In embodiments, the method further comprises determining, from the trained model, for a device belonging to the population, a value of state of health and associated uncertainty for a given duration of operation of the device.

In embodiments, the method further comprises inferring from the mean value of state of health and associated uncertainty for a given duration of operation of the device, and from an expected lifetime of the model of device, a remaining useful life of the device and associated uncertainty.

In embodiments, the device is a battery or a fuel cell.

It is also disclosed a computer-program product comprising code instructions for implementing the method according to the above description, when it is implemented by a computer.

It is also disclosed a non-transitory computer-readable storage having stored thereon a computer program comprising instructions, the computer program being loadable into a processor and adapted to cause the processor to carry out, when the computer program is run by the processor, the method according to the above description.

It is also disclosed a device for predicting the state of health of a battery, comprising a computer and a memory, the device being configured for implementing the method according to the above description.

It is also disclosed a distributed computing system comprising a server storing a model trained by implementation of the method according to the description above, and a battery management system or a fuel cell management system, wherein the battery management system or fuel cell management system is configured to:

- receive a duration of operation of a battery or a fuel cell, respectively,
- communicate said duration of operation to the server,
- and the server is configured to obtain, from said duration of operation and by application of the model, an indicator comprising at least one of a state of health or remaining useful life of the battery or fuel cell, and return said indicator to the battery management or fuel cell management system, respectively.

The disclosed method enables characterizing the evolution of the state of health of a population of device, such as a battery or a fuel cell, taking into-account the inter-device variability and the evolution of said variability with the duration of operation. The characterization may be performed over all the trajectory of degradation of state of health of the device. In embodiments, the characterization extends to values of duration of operation that have not been observed in the training database. This spares the need for observations over all possible values of duration of operation, which results in an important gain of time and resources (e.g. in the case of batteries: number of charges) for gathering the training data.

Characterizing adequately a population of devices enables a better determination of a lifetime of the devices.

The disclosed method can also be applied for predicting a state of health corresponding to a future duration of operation for a device belonging to the population based on which the training has been performed.

DESCRIPTION OF THE DRAWINGS

Other features and advantages of the invention will be apparent from the following detailed description given by way of non-limiting example, with reference to the accompanying drawings, in which:

- Figure 1, already presented, represents degradation of the capacity of a population of lithium-ion batteries with the number of cycles of operation,
- Figure 2 displays the predictions of a model according to an embodiment,
- Figure 3 represents the compared evolution of standard deviation between a model with and without stationary variance, and empirical standard deviation of a population of batteries.
- Figures 4a and 4b represent the evolution with the number of training devices of MAE for prediction models having respectively stationary and non-stationary variances.
- Figures 5a and 5b represent the evolution with the number of training devices of NLPD for prediction models having respectively stationary and non-stationary variances.
- Figure 6a and 6b represent the compared prediction of a model according to the first embodiment and a model according to another embodiment, in which the model comprises constraints regarding the second derivative of a term, and the predictions cover a range of durations of operation that is larger than the range of durations of operation observed among the training data.
- Figures 7a to 7c represent compared MAE values of models as a function of the predictive range in number of cycles of operation, i.e. as a function of the number of cycles of operation for which a prediction is made and that are not observed in the training database.
- Figures 8a to 8c represent compared NLPD values of models as a function of the predictive range in number of cycles of operation.

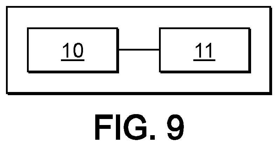

- Figure 9 schematically represents a device for predicting a state of health of a target device.

DETAILED DESCRIPTION OF AT LEAST ONE EMBODIMENT

Embodiments of a method for characterizing the evolution with duration of operation of the state of health of a population of devices will now be disclosed. The population of devices comprises a plurality of devices of a same model. The devices may be batteries, for instance lithium-ion batteries, or fuel cells, for instance hydrogen fuel cells.

When the devices are batteries, an indicator of the state of health of the device can be a capacity value or an internal resistance value. When the target device is a fuel cell, an indicator of the health of state of the device can be a percentage of loss in a power or voltage generated by the fuel cell with reference to an initial value.

As disclosed in more details below, the method comprises training a model configured to predict, for a duration of operation of a device, a state of health of the device.

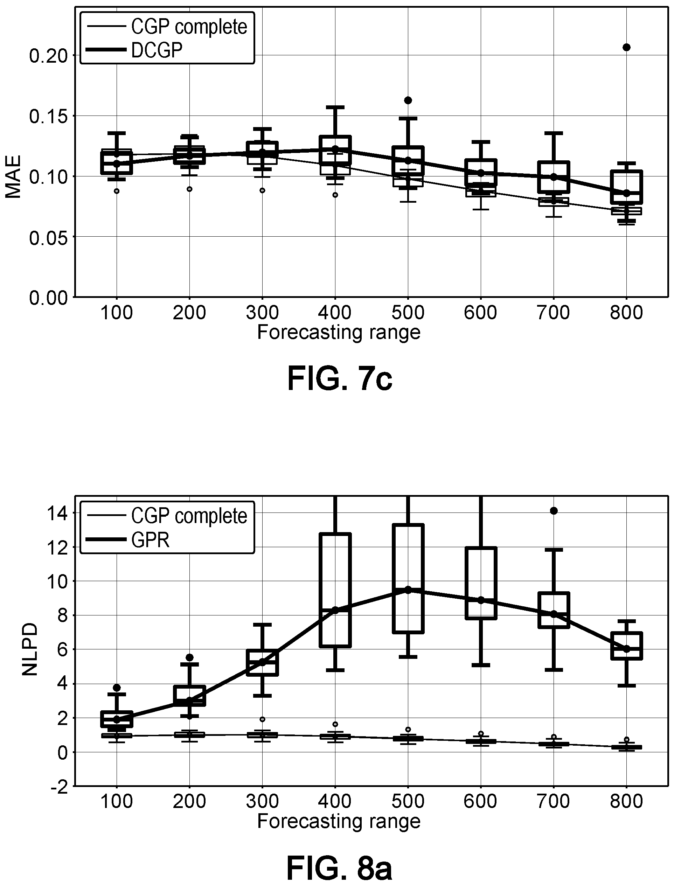

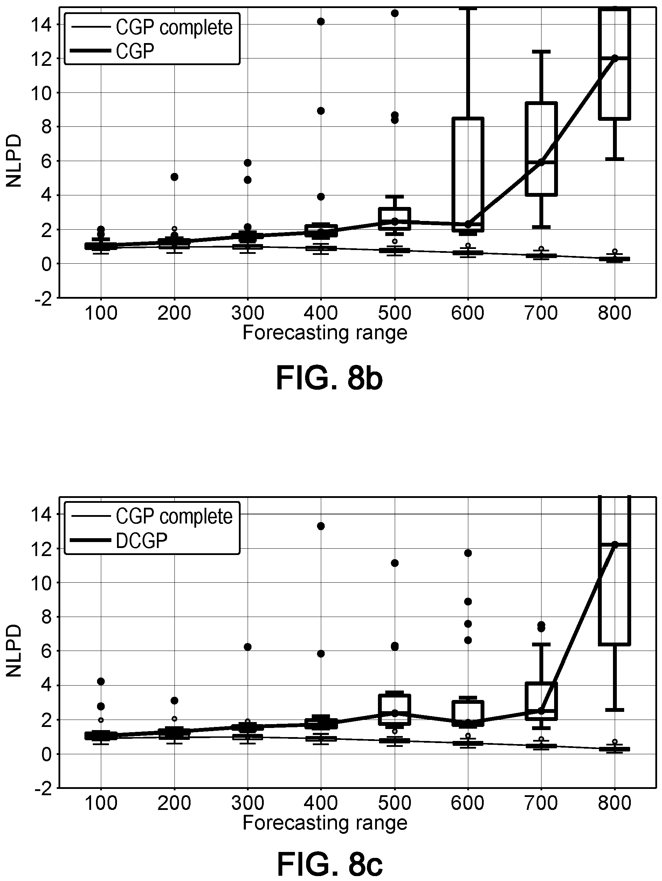

With reference to figure 8, the method, and in particular the training of the model may be implemented by a computing device 1 comprising a computer 10 and a memory 11. The computer 10 may include one or more processors, microprocessors, microcontrollers, CPUs or GPUs. The memory 11 may be a magnetic hard disk, solid-state disk, optical disk, electronic memory or any type of computer-readable storage medium. The memory stores a computer program, in the form of a set of program-code instructions to be executed by the computer in order to implement all or part of the steps of the method detailed below. The memory 11 may also store the trained model disclosed below.

In embodiments where the devices are batteries, the model once trained may be integrated in a battery management system (BMS) and executed by a computing device of the BMS, enabling the BMS to estimate the state of health of the battery and determine continuously the remaining useful life of the battery. In embodiments where the devices are fuel cells, the model once trained may be integrated in a fuel cell management system, and executed by a computing device of the fuel cell management system. In embodiments, the model once trained may be stored in a remote server, remotely accessible by a telecommunication network. For instance, a local computer integrated in a battery of fuel cell management system can send requests to interrogate the model and receive data from a remote computing device storing the model.

The duration of operation of the target device may be expressed as a cumulated number of hours of operation of the device, for instance since the manufacturing of the device. Alternatively, in the case of a battery, it may be expressed as a number of cycles of operation, i.e. a number of cycles of charging and discharging the battery. Alternatively, it can also be the cumulative quantity of the capacity that is charged and discharged, also called Ampere hour throughput. When the target device is a fuel cell, the duration of operation may also be expressed as a cumulative electrical energy delivered by the fuel cell, for instance since the manufacturing of the fuel cell.

The method comprises training a model on a database comprising, for a population B comprising a plurality of devices of the same type, values t of duration of operation of the devices and corresponding values y of an indicator of state of health of the devices.

By "same type as the target device", it is meant that all the devices of the database have the same design. For instance, the devices may be of a same make and model, or they may be devices manufactured from a same production batch.

In embodiments, the database comprises, for each device b, a plurality of values t of duration of operation and corresponding values y of an indicator of state of health of the device. In embodiments, for each device, the plurality of values of duration of operation extends from the reference target device being in new condition (i.e. minimum duration of operation) to a duration of operation where the reference target device is no longer fit for use. However, and as will be explained in more details below, this is not necessary and the database may alternatively comprise of state of health of devices corresponding to durations of operation which extend between 0 and a maximum duration of operation which may be less than a duration for which at least one of the devices is no longer fit for use. A device may be considered as being no longer fit for use when its performances are degraded by a predefined quantity, with reference to the performances of the same device in new condition.

In embodiments, the model is a random process, comprising at least a sum of at least one term, being a random process, representing average evolution of the state of health of the population with duration of operation, and at least one term, also being a random process, representing an inter-device variability of the degradation of the state of health, at equal duration of operation.

In what follows, it is noted x=(t,b) where t is the duration of operation of a device, b refers to a device among the population B, and y(t,b) is the value of the indicator of state of health.

According to an example, the model is defined as:

$$y(t,b) = \mu(t) + v(t,b) \qquad (1)$$

Where $\mu(t)$ is the term representing the average evolution of the state of health of the population B, and $v(t,b)$ is the inter-device variability, i.e. the gap between the state of health of a device of the population and the mean, for a given duration of operation, said gap being variable among the population of devices and evolving with duration of operation.

In embodiments, the model may further comprise a term $\varepsilon$ corresponding to a measurement error, and be a linear combination of the terms, for instance a sum:

$$y(t,b) = \mu(t) + v(t,b) + \varepsilon \qquad (2)$$

The measurement error may have a Gaussian distribution with null average constant variance $\varepsilon \sim \mathcal{N}(0, \sigma_\varepsilon^2)$ where $\sigma_\varepsilon^2$ is the value of the constant variance.

The term $\mu$ representing the average evolution of the state of health of the population with duration of operation corresponds to the shared trend of state of health degradation with duration of operation. In embodiments, this term may be a Gaussian Process.

A Gaussian process f is a random process defined thanks to a mean function m and a kernel k, corresponding to a covariance function, such that for an input x:

$$m(x) = \mathbb{E}[f(x)] \qquad (3)$$

Where $\mathbb{E}$ is the expected value or mean of the function f, and

$$k(x, x') = \mathbb{E}\big[(f(x) - m(x)(f(x') - m\ (x'))\big] \qquad (4)$$

Regarding the term representing the average evolution of the state of health of the population with duration of operation, the Gaussian Process may be defined as:

$$\mu \sim \mathcal{GP}(m_\mu, k_\mu)$$

where $m_\mu$ is the mean function, which can be selected constant and equal to the empirical mean of the training data. The kernel $k_\mu$ can be chosen as an infinitely derivable function to properly model the degradation trend; for instance a Squared Exponential (SE) model, defined as:

$$k_{SE}(x, x') = \sigma_\mu^2 \exp\left(-\frac{\|x - x'\|^2}{2l_\mu^2}\right) \qquad (5)$$

Where $\sigma_\mu$ is the standard deviation modeling the amplitude of the variations of $\mu$ whereas $l_\mu$ is the length-scale, i.e. a parameter describing the characteristic distance of variations of the function $\mu$. Roughly speaking, for two positions x and x' with a distance superior to $l_\mu$, $\mu(x)$ and $\mu(x')$ are almost independent, their correlation is close to zero. $\sigma_\mu$ and $l_\mu$ are hyperparameters learnt during training of the function.

The term representing the inter-device variability of the degradation of the state of health, for equal duration of operation, is non-stationary, because the variance of this term evolves with duration of operation, to account for the growing inter-device variability of the state of health with duration of operation, as visible for instance on figure 1.

In embodiments, the term may be a non-linear combination of random processes, for instance a non-linear combination of Gaussian Processes.

According to an embodiment, the term is a product of:

- a first Gaussian Process $y_{standard} \sim GP(m_y, k_y)$, corresponding to a deviation of the predicted quantity from the average, said first Gaussian Process having constant variance with duration of operation, and
- a positive random process $\sigma_0$, corresponding to the evolution of the standard deviation, and hence of the variance, of the inter-device variability with duration of operation:

$$v(t, b) = \sigma_0(t) . y_{standard}(t, b) \qquad (6)$$

As $\sigma_0$ accounts for the evolution of the standard deviation of the inter-device variability with duration of operation, $y_{standard}$ is constructed so as to have a constant variance with duration of operation, i.e. it is set equal to 1.

Regarding the kernel of $y_{standard}$, denoted $k_y$ we suppose that the deviations of two different devices from the trend of the population, are independent. To impose that, the kernel is chosen such that:

$$k_y(x, x') = \hat{k}_y(t, t')I(b = b') \qquad (7)$$

With I an indicator function.

Moreover, the kernel can be chosen as being stationary meaning that $\hat{k}_y(t,t') = \hat{k}_y(t - t')$, which is the case of mostly used kernels, and thus having constant variance. Indeed, a consequence of stationarity is that $\hat{k}_y(t,t) = \hat{k}_y(0) = constant$, i.e. the variance of the process does not depend on t and is constant. In embodiments, the kernel may be chosen between the two following kernels, since the SE kernel is too smooth to model individual variations of state of health of devices:

- Matérn 5/2 kernel defined as:

$$k_{Ma52}(t, t') = \sigma_y^2\left(1 + \frac{\sqrt{5}\|t - t'\|}{l_y} + \frac{5\|t - t'\|^2}{3l_y^2}\right)\exp\left(-\frac{\sqrt{5}\|t - t'\|}{l_y}\right) \qquad (8)$$

- Matern 3/2 kernel defined as:

$$k_{Ma32}(t,t') = \sigma_y{}^2 \left(1 + \frac{\sqrt{3}\|t-t'\|}{l_y}\right)\exp\left(-\frac{\sqrt{3}\|t-t'\|}{l_y}\right) \quad (9)$$

$\sigma_y{}^2$ is the variance of $y_{standard}$, it is set equal to 1.

Regarding the mean $m_y$, it is set constant equal to 0.

$\sigma_0$ represents evolution with time of inter-device variability and can be defined according to the evolution of inter-device variability that needs to be learnt.

In embodiments, in order to ensure positivity, $\sigma_0$ is the combination of a random process and a positive deterministic function applied to the random process. The positive deterministic function may for instance be chosen as exponential or softplus function. The random process may be a Gaussian Process.

Accordingly, $\sigma_0$ may for instance be written as:

$$\sigma_0(t) = P\big(\eta(t)\big) \quad (10)$$

Where P is the deterministic positive function which may be chosen among the examples given above, and $\eta(t)$ is a Gaussian Process which can be chosen with a constant mean function $m_\eta$ that is estimated during the training and a kernel that can be chosen for instance as a SE kernel.

Training the model using the database corresponds to determining the hyperparameters of the model i.e. in the case of a model according to equation (2) above, the parameters m and k that are not already set, for which the posterior law of the terms of the model $p(\mu, \eta, \mathbf{y}_{standard}|\mathbf{y})$ best corresponds to the observation of the database, where y=y(X), $\mu$= $\mu$(X), $\eta$= $\eta$(X) and ystandard= ystandard(X).

In embodiments, and in particular when the model comprises a non-linear combination of Gaussian Processes, the training comprises approximating the model, by variational inference, i.e. determining a model approximating the posterior law. Let us rewrite the parameters ($\mu$, $\eta$, $y_{standard}$) from which the model depends as $\mathbf{f}_1,..,\mathbf{f}_C$ where C =3. For $\mathbf{f}_c = f_c(X)$ the dependence is described by the likelihood $p(\mathbf{y}|\mathbf{f}_1, ... \mathbf{f}_c)$ Writing $\theta$ the concatenation of the functions $\mathbf{f}_c$, i.e. ($\mu$, $\eta$, $\mathbf{y}_{standard}$), the training comprises computing an approximation of the posterior law $p(\theta|\mathbf{y})$. For that, a family of variational distribution is defined and writing q($\theta$) an element of this distribution, it has to respect the following condition:

$$q(\boldsymbol{\theta}) = \prod_{c=1}^{C} q(\mathbf{f}_c)$$

Compared to the exact posteriors $p(\mathbf{f}_c|\mathbf{y})$ are replaced by $q(\mathbf{f}_c)$, supposed independent, for which we take $q(\mathbf{f}_c) = \mathcal{N}(\mathbf{f}_c|\mu_c, S_c)$ . These distributions depend on $(\mu_c, S_c)_{c\in[\![1,C]\!]}$ , which are variational hyperparameters to be optimized.

The variational hyperparameters are determined by minimization of the Kullback-Leibler divergence between the true unknown posterior and its variational approximation, denoted KL(q($\theta$) |p($\theta$|$\mathbf{y}$)).

The minimization of the KL divergence is equivalent to minimizing the evidence lower bound which can be written:

$$\mathrm{ELBO} = \mathbb{E}_q[\log p(\boldsymbol{y}|\boldsymbol{\theta})] - KL(q(\boldsymbol{\theta})\|p(\boldsymbol{\theta}))$$

Or in the case of the model of equations (2) and (6) combined:

$$\mathrm{ELBO} = \sum_{i=1}^{N} \int q(\mu)q(\boldsymbol{\eta})q(\boldsymbol{y}_{standard})\, p\big(y_i\big|\mu_i, \boldsymbol{\eta}_i, y_{standard,i}\big)d\mu d\boldsymbol{\eta} d\boldsymbol{y}_{standard}$$
$$+ KL(q(\mu)\|p(\mu) + KL(q(\boldsymbol{\eta})\|p(\boldsymbol{\eta}) + KL(q(\boldsymbol{y}_{standard})\|p(\boldsymbol{y}_{standard})$$

Thus in embodiments the training of the model comprises determining the hyperparameters and variational hyperparameters minimizing the ELBO function above.

Once the model is trained, a mean value of state of health of a device for a given duration of operation and associated uncertainty are obtained. The mean value corresponds to $\mu(t)$ and the associated uncertainty can correspond to the standard deviation of the model for duration of operation t. An uncertainty range can thus be defined as being centered on the mean value and having a width equal to the standard deviation Alternatively, the uncertainty range can correspond to a range of values of of state of health in which a device of a given duration of operation has a determined probability to be, for instance 0.9, or 0.95.

In embodiments, the mean values and associated uncertainty for a plurality of durations of operation may be used to determine an expected lifetime of a device corresponding to the population of devices for which the model has been trained. The expected lifetime can for instance correspond to a duration of operation for which conditions are met regarding the mean value and optionally the uncertainty of the state of health. The expected lifetime also corresponds to a duration of operation that the considered device has a given probability to reach. For example, the expected lifetime can correspond to a duration of operation at which the mean value of state of health drops below a determined threshold (corresponding to a probability of 0.5). An uncertainty on said lifetime can also be determined by determining the values of durations of operation at which the lower and higher ends of the uncertainty range drop below said threshold.

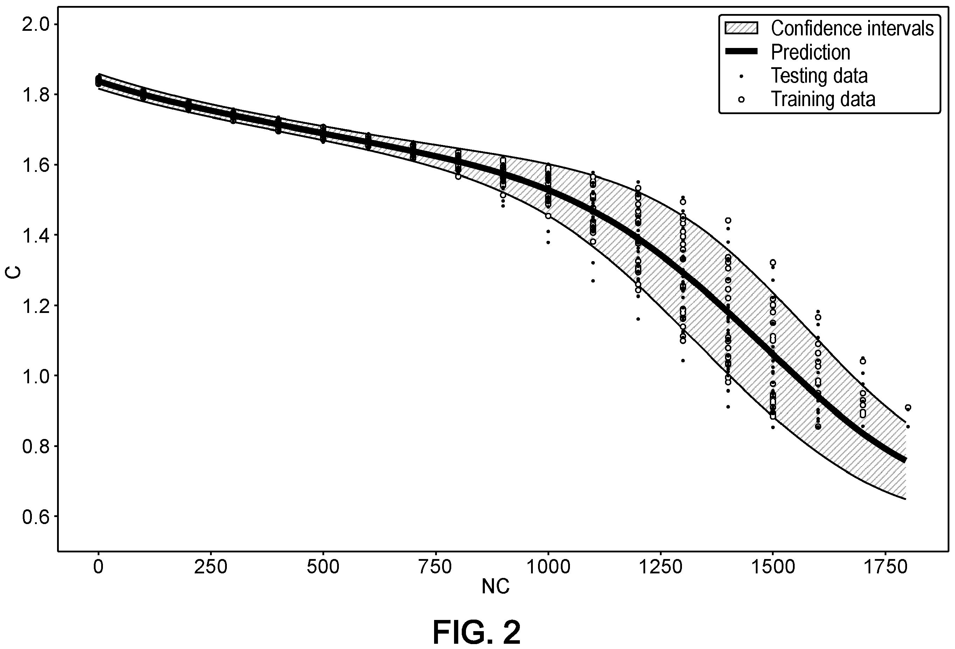

With reference to figures 2 to 5b are shown results obtained with a model trained on a population of lithium-ion batteries, where the regression function is in the form of the following equation:

$$y(t,b) = \mu(t) + P\big(\eta(t)\big).y_{standard}(t,b) + \varepsilon \qquad (11)$$

where $\mu$, $\eta$ and $y_{standard}$ are gaussian processes defined as follows:

- $m_\mu$ is the empirical mean of the training data and $k_\mu$ is a SE kernel,
- $m_y$ is null and $k_y$ is a Matern 3/2 kernel,
- $m_\eta$ is a constant function and $k_\eta$ is a SE kernel,
- P is an exponential function.

Replacing $k_y$ by a Matern 5/2 kernel and P by a softplus transform does not change the results.

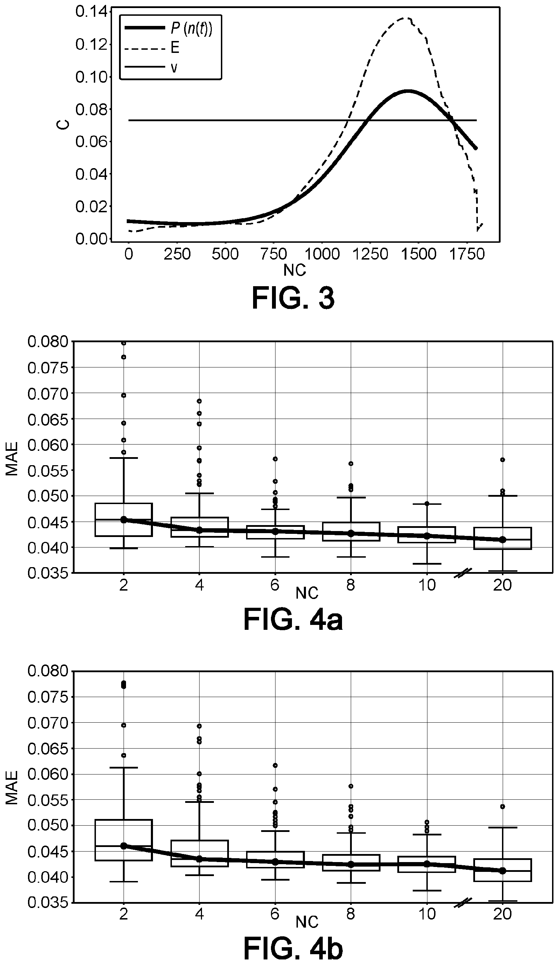

In figures 2 and 3, the duration of operation is expressed in abscissa by a number of cycles NC and the state of health of the batteries is expressed in ordinates by a capacity C.

In figure 3 is plotted the evolution of the term $(P(\eta(t)))$ representing the evolution of the standard deviation of the inter-device variability with duration of operation. In this figure as well, confidence intervals are so narrow that they correspond to the thickness of the line. In comparison is shown the empirical standard deviation E computed on the training dataset (all batteries of the training dataset every 5 cycles). Also, is shown the constant standard deviation of a regression function according to equation 2 above where the term representing inter-device variability v has constant variance. For the 700 first cycles the empirical standard deviation is low and almost constant. The term representing the evolution of the standard deviation of the inter-device variability fits well to the empirical standard deviation while the term of constant standard deviation largely overestimates it. Then around 700 cycles the empirical variance starts to increase quickly. We see a similar behavior for the term $P(\eta(t))$ even if it does not increase as fast. After cycle 1100 the term having constant variance seems to underestimate the real variance. So does the term $P(\eta(t))$ but the error is smaller.

Complete predictions are shown in figure 2. The mean value of the state of health of the population of devices according to the number of cycles NC corresponds to the thick line, and the associated uncertainty corresponds to the confidence interval. The predicted trend fits well the training and testing data, and one can notice that the confidence intervals are much thinner on first cycles than on later cycles (NC>700 in this example), which fits well the evolution of inter-device variability.

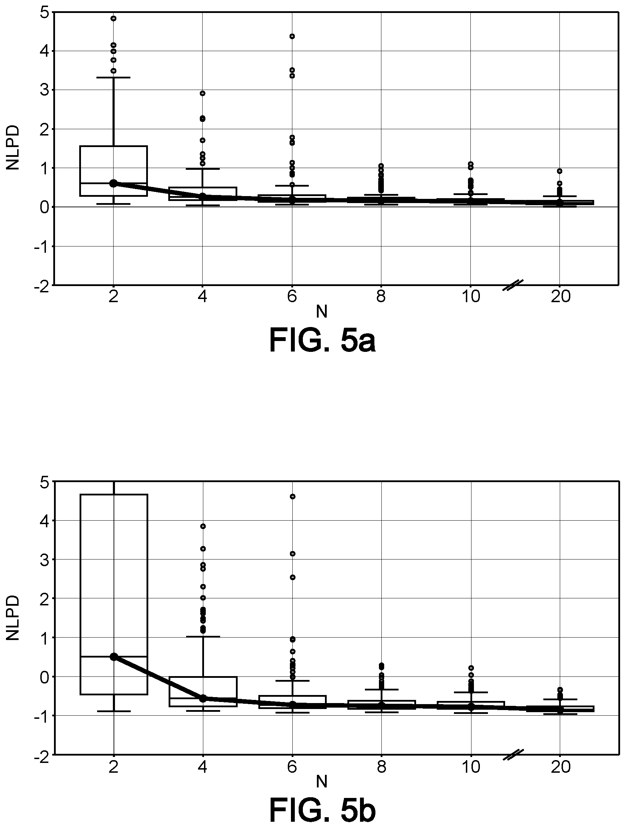

With reference to figures 4a and 4b and 5a and 5b are also shown compared quantitative results obtained for a regression function having a term representing inter-device variability with non-constant variance (figures 4b and 5b) and for a regression function with a term representing inter-device variability having a constant variance (figures 4a and 5a).

Figures 4a and 4b represent compared values of mean absolute error MAE obtained for the compared trained functions, plotted against the number of training devices N. MAE is defined as follows:

$$MAE = \frac{1}{n_{test}} \sum_{i=1}^{n_{test}} |y_i^* - \hat{y}_i|$$

With $n_{test}$ the number of observations in the testing set, $y_i^*$ the i-th state of health value, not used to train the model, i.e. not among the training data, and $\hat{y}_i$ the prediction.

Figures 5a and 5b represent compared values of negative log predictive density NLPD for the compared trained functions, plotted against the number of training devices N. NLPD is defined as follows:

$$NLPD = -\frac{1}{n_{test}} \sum_{i=1}^{n_{test}} \log p(y_i^* | \boldsymbol{x}_i)$$

Where $p(y_i^* | x_i)$ is the predicted density of y at input $x_i$. As MAE, it is sensitive to errors in mean prediction but at the same time it penalizes under or overestimated uncertainties. It has to be as small as possible.

The indicators MAE and NLPD were computed a hundred times with randomly selected training devices, and each time the fitted function was then tested on the remaining devices. These indicators were computed for six functions including four functions with a term representing inter-device variability with non-constant variance and two with a term representing inter-device variability with constant variance. Regarding the latter, the term representing inter-device variability with constant variance was a Gaussian Process with either a Matern 3/2 or Matern 5/2 kernel. The function with a term representing inter-device variability with non-constant variance were according to equation 11 in which $\eta$ had either a Matern 3/2 or Matern 5/2 kernel and the positive function was either the exponential function of softplus function. The differences due to the choice of the kernel or the positive function were small as compared to the differenced between the function in which the inter-device variability had constant or non-constant variance. Figures 4a to 5b are plotted for models having Matern 3/2 kernel and exponential positive transform.

Regarding mean predictions (MAE), no major difference can be observed between function with and without an inter-device variability term having constant variance (figures 4a and 5b). However, regarding uncertainties, it can be noticed that NLPD decreases with the number of batteries with a function having an inter-device variability term of constant variance, but remains above zero. When a model having an inter-device variability term of non-constant variance is used, the value of NLPD reaches a significantly lower value, close to -1, and improves quickly to give reasonable performance even with few batteries.

It thus confirms that the use of a heteroscedastic model (i.e. having non constant variance) improves the predicted uncertainties while keeping similar performance than homoscedastic models for mean prediction.

In embodiments, when the model comprises a non-linear combination of Gaussian Processes, and in particular when the model is according to equation (2) with v according to equation (6) above, the training comprises adding to the database data corresponding to prior knowledge of the tendency of at least one term of the model with duration of operation of the devices, and in particular data representative of the monotony or concavity, i.e. of the first or second derivative, respectively, of at least one term of the model. The prior knowledge can for instance be obtained from previously performed tests or can be derived from the knowledge of physical and/or chemical phenomena involved with the operation of the device.

For instance, the mean $\mu$ state of health of a battery is known in most settings to be monotonic, i.e. $\frac{d\mu}{dt}$ having a fixed sign, that is decreasing when the indicator of state of health is capacity, or increasing when said indicator is the internal resistance.

Moreover, an acceleration of health degradation is often observed after a certain time, which corresponds to prior knowledge on $\frac{d^2\mu}{dt^2}$ .

Prior knowledge is also available for inter-batteries variability $\sigma_0$ because the initial state of health is often identical or nearly identical for a population of batteries, but progressively differentiates, which corresponds to an increase of $\sigma_0$.

The prior knowledge on the tendency of a component $f_d$ may be taken into account by adding, to the database, virtual observations $\boldsymbol{z}^v$ taking values in {0,1} depending on the monotony (first derivative) or the concavity (second derivative) of $f_d$.

According to a non-limiting example, let us denote $f'_d = \frac{\partial f_d}{\partial t}$ the first derivative of a component $f_d$ of the model, which may be equal for instance to $\mu$, $\eta$ (when $\sigma_0 = P(\eta)$), or $y_{standard}$. The virtual observations may be equal to 0 if $f_d$ is decreasing, and 1 if $f_d$ is increasing.

To integrate them in the model it is supposed that

$$z_i^v | \mathbf{f}'_{d,i} \sim \mathcal{B}(s(\mathbf{f}'_{d,i}))$$

Where B is the Bernouilli distribution, $\mathbf{f}_d = f'_d(X^v)$, and s may be a sigmoid function for a mapping from R to [0,1], a logit function or the inverse of the normal cumulative distribution function. Thus if $f_d$ is positive with high probability at some location, a virtual variable at the same location has a high probability of being equal to 1 and conversely. The same applies mutatis mutandis is a second derivative is used instead of a first derivative to add knowledge about concavity.

Including virtual observations, the model has an extended likelihood $p(\mathbf{y}, \mathbf{z}^v | \mathbf{f}_1, ..., \mathbf{f}_C, \mathbf{f}'_d)$, using the same notations as above for $\mathbf{f}_i$, which can be factorized as follows:

$$p(\mathbf{y}, \mathbf{z}^v | \mathbf{f}_1, ..., \mathbf{f}_C, \mathbf{f}'_d) = \prod_{i=1}^{N} p(\mathbf{y}_i | \mathbf{f}_{1,i}, ..., \mathbf{f}) \prod_{j=1}^{N^v} p(\mathbf{z}_j^v | \mathbf{f}'_{dj})$$

Taking into account the additional parameter $\mathbf{f}'_d$, the variational distribution presented above is updated as follows, keeping the same variational hyperparameters:

$$q(\theta) = p(\mathbf{f}'_d | \mathbf{f}_d) \prod_{c=1}^{C} q(\mathbf{f}_c)$$

The updated evidence lower bound, denoted $ELBO_d$ becomes:

$$ELBO_d = ELBO + \sum_{j=1}^{N^v} \int log p(\mathbf{z}_j^v | \mathbf{f}'_{dj}) q(\mathbf{f}'_{dj}) d\mathbf{f}'_{dj}$$

With $q(\mathbf{f}'_{dj}) = \int p(\mathbf{f}'_{dj} | \mathbf{f}_{dj}) q(\mathbf{f}_{dj}) d\mathbf{f}_{dj}$, having an exact analytic equation, using Gaussian properties and the following general properties:

$$Cov\left[\frac{\partial f(t)}{\partial t}, f(t')\right] = \frac{\partial Cov[f(t), f(t')]}{\partial t}$$

$$Cov\left[\frac{\partial f(t)}{\partial t}, \frac{\partial f(t')}{\partial t}\right] = \frac{\partial^2 Cov[f(t), f(t')]}{\partial t^2}$$

Similar results can be obtained for second order derivative.

In that case, the model improves the predictions of the evolution of state of health of a device for a given duration of operation, even if the duration of operation is not among the observations of the database, or said otherwise, even if duration of operation exceeds the durations of operation for which state of health values are available in the database.

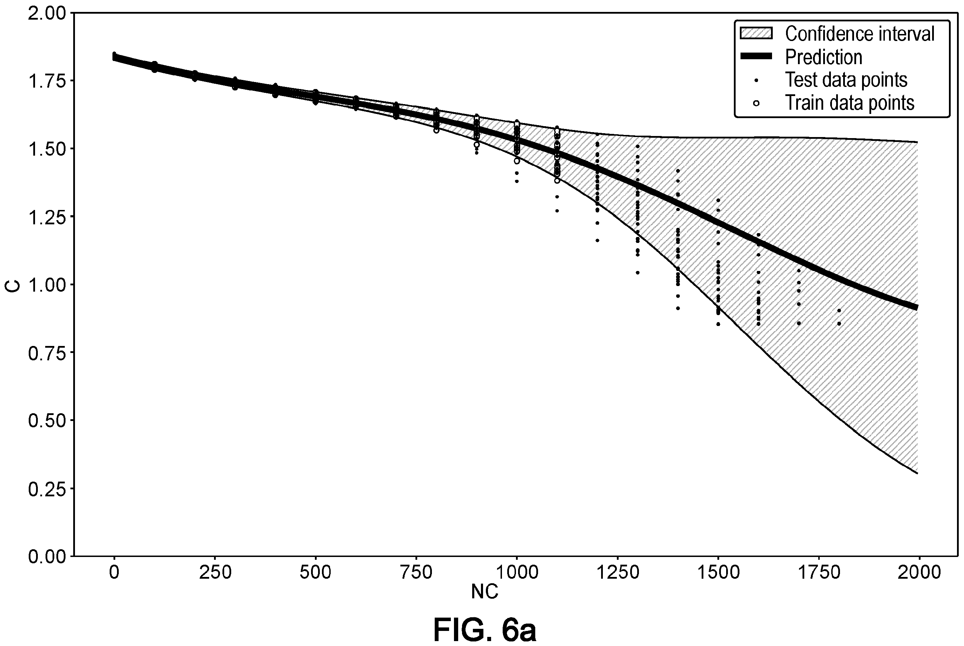

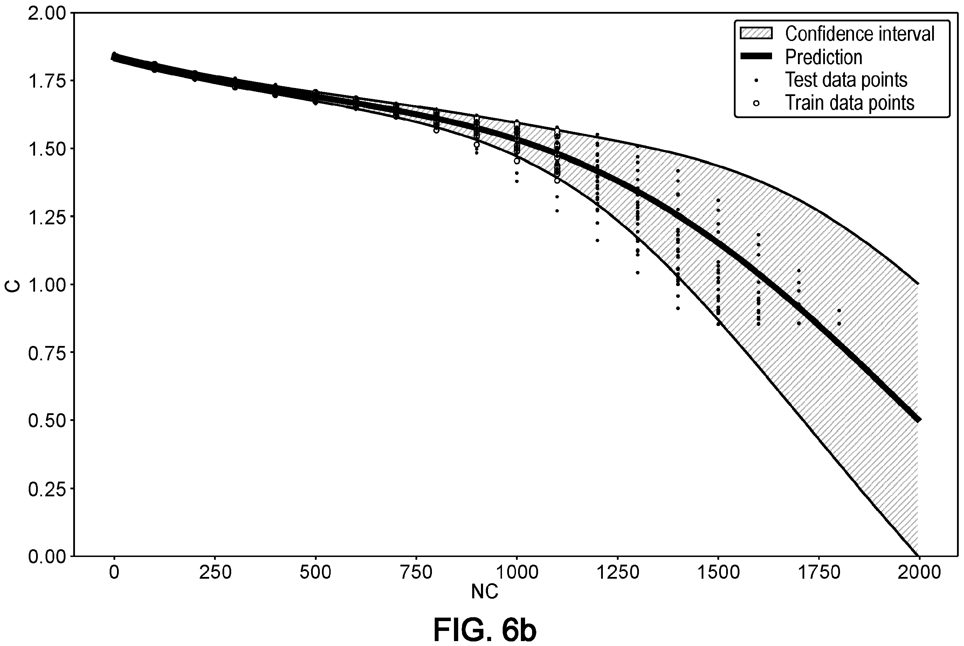

With reference to figure 6a and 6b, are shown compared predictions of models according to equation (11) above, where the predictions extend over durations of operations that are not present in the training database. More specifically, the training dabatase comprised observations until 1100 cycles of observations and the models were applied to predictions until 2000 cycles. In figure 6a, no constraint was added to the model regarding the trend of one its terms. In figure 6b, a constraint was added to impose negativeness of the second derivative of μ after cycle 500 and until cycle 2000, corresponding to an acceleration of the degradation of the state of health. As the trend on the second derivative was well observed on the training data, virtual points were placed only in the forecasting range, i.e. in the range of number of cycles not present in the training data, i.e. between 1100 and 2000 cycles. One point was added every 25 cycles.

One can notice that the mean prediction (thick line) is much more satisfactory with the constrained model than without constraint. After 200 cycles predicted mean clearly overestimate less testing data. Uncertainty modeling (confidence interval) is also improved with much narrower confidence intervals still including most testing points.

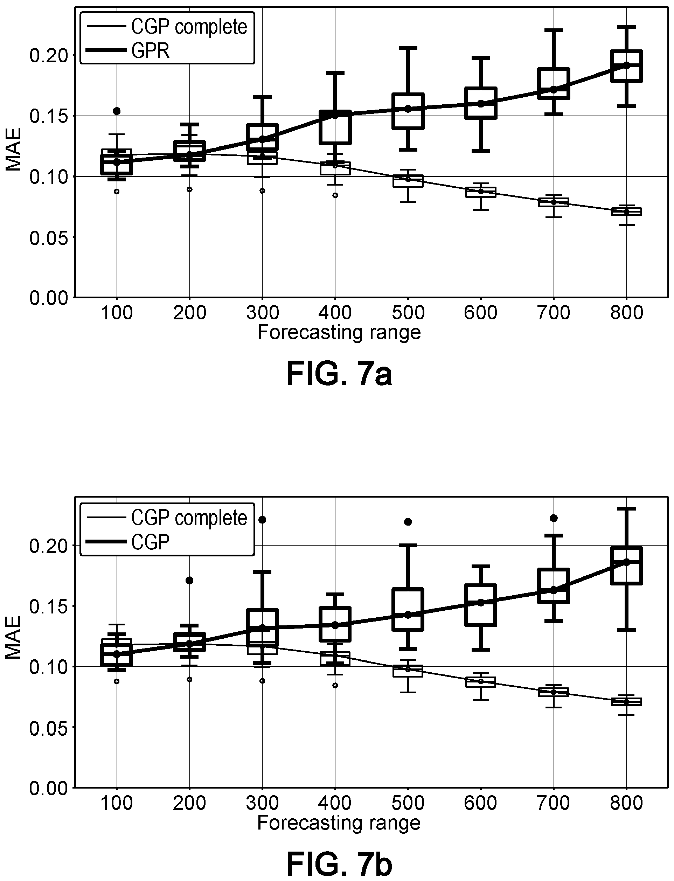

With reference to figures 7a to 7c and 8a to 8c respectively, are also shown the evolution of MAE and NLPD indicators for compared models and as a function of the forecasting range, i.e. the range of duration of operation (in the figures it corresponds to a number of cycles) for which the model is used for prediction and which is not present in the training database.

These indicators MAE and NLPD were considered for cycles up to 1500, with a predictive range of duration of operation between 100 and 800 cycles. That means that compared models are trained on a testing batch of batteries from cycle 0 to cycle 1500 minus the number of cycles corresponding to the predictive range (e.g. 700 when the predictive range is 800), and then they are tested on a testing batch of batteries on cycles 1500 minus the number of cycles corresponding to the predictive range (e.g. 700 when the predictive range is 800) to 1500. The compared models comprise a model according to equation (11) above without constraint, denoted CGP, the same model with second derivative constraint, denoted DCGP, and a Gaussian Process model with squared exponential kernel and constant prior mean equal to the empirical mean of the data, denoted GPR. As a baseline for comparison, a CGP model was also trained on all cycles (denoted CGP Complete in the figures).

It can be noted that both GPR and CGP models have a similar behavior with an error increasing with forecasting range. On the other hand DCGP has a performance much closer to the reference even for a high forecasting range.

Then considering NLPD, it is apparent as in figures 5a and 5b above that the GPR model is not able to anticipate the inter-battery variability increase. Then comparing CGP and DCGP for a forecasting range under 500 cycles observed behavior is qualitatively similar but with small gain with NLPD. However after cycle 500 NLPD increases suddenly for CGP model, which thus reaches its limits. The limit is reached later for the DCGP model, at cycle 800.

Hence it is shown that using constraints on first or second derivatives of some terms of the model enables enhancing the prediction capability of a model, thereby reducing the needs for extensive training database covering the whole possible range of duration of operation of the considered devices.

The models presented above may thus be used, once trained, to provide the mean value of state of health of the population of devices and associated uncertainty for a given duration of operation.

It may also be interrogated for one particular device of the population, and for a given duration of operation, in order to characterize the state of health of the device and the corresponding uncertainty. From this, and from an expected lifetime of the device, it is possible to determine a remaining useful life of the device.

**Claims**

1. A computer-implemented method for characterizing the evolution of the state of health of a population of devices with duration of operation,

   the method comprising training a model on a database comprising, for each device among the population of devices, a value of duration of operation of the device and a corresponding state of health of the device, said model being a random process comprising at least the sum of:

   - a term representing average evolution of the state of health of the population with duration of operation, and
   - a term representing an inter-device variability of the degradation of the state of health at equal duration of operation, the variance of said term evolving with the duration of operation.

2. The method according to claim 1, further comprising inferring, from said training, a mean value and associated uncertainty of the state of health of devices of the population, for at least one duration of operation.

3. The method according to any of the preceding claims, wherein the term of the regression function representing inter-device variability is a non-linear combination of random processes.

4. The method according to any of the preceding claims, wherein the term of the regression function representing inter-device variability is a non-linear combination of Gaussian Processes.

5. The method according to any of the preceding claims, wherein the term of the regression function representing inter-device variability is a product of:

   - a first Gaussian Process, corresponding to a deviation of the predicted quantity from the average, said first Gaussian Process having constant variance with duration of operation, and
   - a positive transform of a second Gaussian Process, corresponding to the evolution of the variation of the deviation with duration of operation.

6. The method according to claim 4 or 5, wherein said training comprises adding to the database data representative of the tendency, with duration of operation, of at least one term of the model.

7. The method according to claim 6, wherein said training comprises adding to the database data representative of the monotony or concavity, with duration of operation, of at least one term of the model.

8. The method according to claim 6 or 7, wherein the database comprises, for the population of devices, values of state of health corresponding to values of duration of operation that are below a maximum duration of operation, and the method further comprises inferring, from said training, a mean value and associated uncertainty of the state of health of devices of the population, for at least one duration of operation exceeding said maximum duration of operation.

9. A computer-implemented method according to any of the preceding claims, further comprising determining, from said training, an expected lifetime of a device of a same model that the devices of the population.

10. The method according to any of the preceding claims, further comprising determining, from the trained model, for a device belonging to the population, a value of state of health and associated uncertainty for a given duration of operation of the device.

11. The method according to claim 10, further comprising inferring from the mean value of state of health and associated uncertainty for a given duration of operation of the device, and from an expected lifetime of the model of device, a remaining useful life of the device and associated uncertainty.

12. The method according to any of the preceding claims, wherein the device is a battery or a fuel cell.

13. A computer-program product comprising code instructions for implementing the method according to any of the preceding claims, when it is implemented by a computer (10).

14. A device (1) for predicting the state of health of a battery, comprising a computer (10) and a memory (11), the device being configured for implementing the method according to any of claims 1-12.

15. A distributed computing system comprising a server storing a model trained by implementation of the method according to any of claim 1 or 3-8, and a battery management system or a fuel cell management system, wherein the battery management system or fuel cell management system is configured to:

- receive a duration of operation of a battery or a fuel cell, respectively,
- communicate said duration of operation to the server,

and the server is configured to obtain, from said duration of operation and by application of the model, an indicator comprising at least one of a state of health or remaining useful life of the battery or fuel cell, and return said indicator to the battery management or fuel cell management system, respectively.

EP 4 312 038 A1

FIG. 1

**FIG. 2**

**FIG. 3**

**FIG. 4a**

**FIG. 4b**

FIG. 5a

FIG. 5b

FIG. 6a

FIG. 6b

EP 4 312 038 A1

FIG. 7a

FIG. 7b

**FIG. 7c**

**FIG. 8a**

FIG. 8b

FIG. 8c

| 10 | | 11 |

FIG. 9

Europäisches
Patentamt

European
Patent Office

Office européen
des brevets

# EUROPEAN SEARCH REPORT

Application Number

EP 22 30 6133

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ZHANG JIANJING ET AL: "Physics-guided Gaussian process for HVAC system performance prognosis", MECHANICAL SYSTEMS AND SIGNAL PROCESSING, ELSEVIER, AMSTERDAM, NL, vol. 179, 30 May 2022 (2022-05-30), XP087102859, ISSN: 0888-3270, DOI: 10.1016/J.YMSSP.2022.109336 [retrieved on 2022-05-30] * the whole document * | 1,13-15 | INV. G01R31/367 G01R31/392 ADD. G06F17/18 |
| E | WO 2022/229611 A1 (UNIV OXFORD INNOVATION LTD [GB]) 3 November 2022 (2022-11-03) * the whole document * | 1,13,14 | |
| A | DENG HUIWEN ET AL: "Degradation trajectories prognosis for PEM fuel cell systems based on Gaussian process regression", ENERGY, ELSEVIER, AMSTERDAM, NL, vol. 244, 10 November 2021 (2021-11-10), XP086962105, ISSN: 0360-5442, DOI: 10.1016/J.ENERGY.2021.122569 [retrieved on 2021-11-10] * the whole document * | 1-15 | TECHNICAL FIELDS SEARCHED (IPC) G01R G06F |
| A,D | RICHARDSON ROBERT R. ET AL: "Gaussian process regression for forecasting battery state of health", JOURNAL OF POWER SOURCES, vol. 357, 31 July 2017 (2017-07-31), pages 209-219, XP093014316, AMSTERDAM, NL ISSN: 0378-7753, DOI: 10.1016/j.jpowsour.2017.05.004 * the whole document * | 1-15 | |

-/--

The present search report has been drawn up for all claims

| Place of search | Date of completion of the search | Examiner |
|---|---|---|
| Munich | 18 January 2023 | Hijazi, Ali |

EPO FORM 1503 03.82 (P04C01)

Europäisches
Patentamt

European
Patent Office

Office européen
des brevets

# EUROPEAN SEARCH REPORT

Application Number

**EP 22 30 6133**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | LIU DATONG ET AL: "Prognostics for state of health estimation of lithium-ion batteries based on combination Gaussian process functional regression", MICROELECTRONICS RELIABILITY : AN INTERNAT. JOURNAL & WORLD ABSTRACTING SERVICE, ELSEVIER SCIENCE LTD, GB, vol. 53, no. 6, 17 April 2013 (2013-04-17), pages 832-839, XP028550112, ISSN: 0026-2714, DOI: 10.1016/J.MICROREL.2013.03.010 * the whole document * | 1-15 | |

-----

TECHNICAL FIELDS
SEARCHED     (IPC)

The present search report has been drawn up for all claims

| Place of search | Date of completion of the search | Examiner |
|---|---|---|
| Munich | 18 January 2023 | Hijazi, Ali |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons
...................................................................................
& : member of the same patent family, corresponding
     document

EPO FORM 1503 03.82 (P04C01)

**ANNEX TO THE EUROPEAN SEARCH REPORT
ON EUROPEAN PATENT APPLICATION NO.**

EP 22 30 6133

This annex lists the patent family members relating to the patent documents cited in the above-mentioned European search report.
The members are as contained in the European Patent Office EDP file on
The European Patent Office is in no way liable for these particulars which are merely given for the purpose of information.

18-01-2023

| Patent document cited in search report | Publication date | Patent family member(s) | Publication date |
|---|---|---|---|
| WO 2022229611 A1 | 03-11-2022 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **R. RICHARDSON et al.** Gaussian Process Regression for forecasting battery state of health. *Journal of Power Sources,* 2017, vol. 357, 209-219

- **D. LIU et al.** Prognostics for state of health estimation of lithium-ion batteries based on combination gaussian processes functional regression. *Microelectronics Reliability,* 2013, vol. 53 (6), 832-839